# EUROPEAN PATENT APPLICATION

(11) **EP 2 479 813 A2**
(43) Date of publication of application: **25.07.2012**
(21) Application number: 11004752.9
(22) Date of filing: 10.06.2011
(51) Int. Cl.: H01L 33/58, H01L 33/48

(54) **Surface-mount light-emitting diode with optical lens**

(30) Priority: 20.01.2011 CN 201120018340 U
(71) Applicant: MLS Co., Ltd., Xiaolan Town, ZhongShan Guangdong 528-400 (CN)
(72) Inventor: Liu, Tianming, Guangdong Province (CN)
(74) Representative: Giannesi, Simona

(57) **Abstract**

The present invention discloses a surface-mount LED with optical lens, comprising a surface-mount LED with a flat plane on the top thereof and an optical lens packaged on said flat plane. The present invention decreases the light emitting angle and increase the luminosity of the LED through the light convergence effect by the optical lens; the present invention also can effectively enhance the usage of the side light rays through the light reflection effect of the cylinder, no extra reflection cup is required; under the condition of the same luminance being provided, less LEDs are used according to the present invention, thereby saving energy and reducing cost.

## Description

### Technical Field

The present invention relates to a surface-mount light emitting diode (LED), and more particularly to a surface-mount LED with optical lens.

### Background Information

Along with the development of our society, energy saving and emission reduction have been firmly rooted, the light emitting diode (LED) lighting thus becomes one of the newly-emerged research directions, in particular the LED light tubes and LED spotlights. However at present the majority of the ordinary surface-mount LEDs used in the field of light tube and spotlight has a rather wide emitting angle and relatively low light intensity, and therefore cannot provide further irradiation distance. In order to enhance the overall light intensity of the LED light tubes or spotlights, a conventional approach is to increase the density or current of the surface mount LEDs, but the increased density which means increased number of the LEDs will significantly increase the manufacturing cost and impede heat dissipation of the system as well, in addition, the increased current will cause rise in light degradation.

### Summary of the Invention

In order to solve the abovementioned problems, the present invention provides a surface-mount LED with optical lens, capable of reducing the emitting angle to converge light rays and consequently to improve the light brightness.

The technical solution adopted by the present invention to solve the abovementioned problems is described as follows:
A surface-mount LED with an optical lens, comprising a surface-mount LED provided with a flat plane on the top thereof, and a one-piece optical lens packaged on said flat plane.

In detail, said surface-mount LED comprises a plastic housing, and a cathode lead and an anode lead set on the bottom of said plastic housing, said plastic housing further contains a reflector cup, in which a LED chip and fluorescent gel or silica gel for packaging said LED chip are provided, the two electrodes of said LED chip are connected to said cathode and anode leads respectively, said one-piece optical lens is packaged above said fluorescent gel or silica gel.

Furthermore, said one-piece optical lens has a cylinder on the bottom thereof and a convex lens on the top thereof, wherein the bottom of said cylinder is packaged on said flat plane.

Furthermore, said cathode and anode leads extend from the bottom of said plastic housing into the reflector cup towards the corresponding sides thereof.

Furthermore, said LED chip is mounted on said cathode lead, and one electrode of said LED chip is connected to said cathode lead while another electrode is connected to the anode lead. Alternatively, said LED chip may be mounted said anode lead, and one electrode of said LED chip is connected to said anode lead, while another electrode is connected to said cathode lead.

The present invention adds an optical lens on a conventional surface-mount LED for better performance, compared to those conventional LEDs, the present invention have the advantages described as follows:
1. By the light converging effect of the convex lens mounted on top, the LED disclosed by the present invention has a reduced emitting angle and improved brightness;
2. A cylinder is added into the optical lens, to lengthen the optical lens and thus to extend the focal length of the light emitting area of the LED, thereby increasing the lighting distance of the LED without changes in the radian of the optical lens, as well as providing better appearance.
3. The design can effectively enhance the usage of the side light rays without an extra reflection cup;
4. Under the condition of the same luminance being provided, less LEDs are used according to the present invention, whereby energy saving and raw material cost reduction are realized;
5. As the number of the components used for a same luminance is reduced, the product has lighter weight and lower raw material cost.

### Description of the Drawings

With reference to the accompanying figures the present invention will be further elaborated.
FIG. 1 is a sectional view of the present invention;
FIG. 2 is a sectional view of the optical lens in the present invention.

### Description of the Embodiments

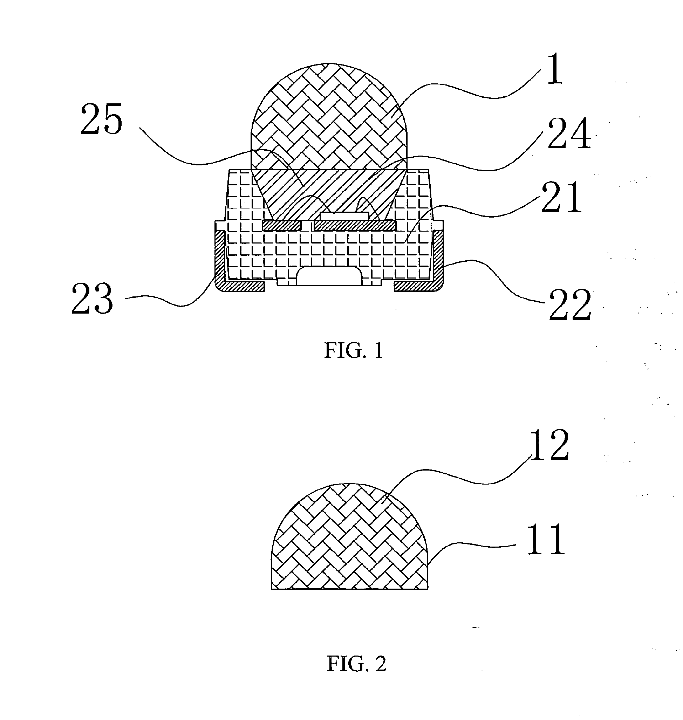

As shown by FIG. 1 and 2, the present invention discloses a surface-mount LED with optical lens, comprising a surface-mount LED with a flat plane on the top thereof, and a one-piece optical lens 1 mounted on said flat plane, wherein the one-piece optical lens has a cylinder 11 on the bottom thereof and a convex lens 12 on the top thereof, the bottom of the cylinder 11 is packaged on said flat plane. In this embodiment, the optical lens is divided into two portions (convex lens and cylinder) not only for a beautiful appearance, but also for converging light rays and enhancing brightness.

In detail, the surface-mount LED comprises a plastic housing 21 and a cathode lead 22 and a anode lead 23 mounted on the bottom of said plastic housing 21, wherein said plastic housing 21 contains a reflection cup, in which a LED chip 24 and fluorescent gel 25 for packaging said LED chip 24 are equipped, and the two electrodes of said LED chip 24 are connected to said cathode lead 22 and anode lead 23 respectively. In addition, said optical lens is packaged above said fluorescence gel 25.

Furthermore, said cathode lead 22 and anode lead 23 extend from the bottom of said plastic housing 21 towards the corresponding sides thereof into the reflection cup, for facilitating the installation of the LED chip 24 and the connection of the two electrodes of the LED chip 24 to the two leads 22 and 23.

Furthermore, the LED chip 24 is mounted on the cathode lead 22, and one electrode of the LED chip 24 is connected to the cathode lead 22 through a metal wire, while the other electrode is connected to the anode lead 23 through another metal wire. Of course, the LED chip 24 could be placed on the anode lead 23, in a similar way to above the two electrodes of the LED chip 24 are connected to the cathode lead 22 and anode lead 23 respectively.

While the invention has been described in terms of what are presently considered to be the most practical and preferred embodiments, it is to be understood that the invention need not be limited to the disclosed embodiment. On the contrary, it is intended to cover various modifications and similar arrangements included within the spirit and scope of the appended claims which are to be accorded with the broadest interpretation so as to encompass all such modifications and similar structure.

## Claims

1. A surface-mount LED (Light Emitting Diode) with optical lens, comprising a surface-mount LED having a flat plane on the top thereof and a one-piece optical lens mounted on said flat plane.

2. The surface-mount LED with optical lens according to claim 1, wherein said surface-mount LED comprises a plastic housing, and a cathode lead and an anode lead mounted on the bottom of said plastic housing, said plastic housing accommodating a reflection cup, in which an LED chip and fluorescent gel or silica gel for packaging said LED chip are provided, the two electrodes of said LED chip being connected to said cathode and anode leads respectively, said one-piece optical lens being packaged above said fluorescent gel or silica gel.

3. The surface-mount LED with optical lens according to claim 1 or 2, wherein said one-piece optical lens has a cylinder on the bottom thereof and a convex lens on the top thereof, the bottom of said cylinder and the flat plane being packaged together.

4. The surface-mount LED with optical lens according to claim 2, wherein said cathode and anode leads extend from the bottom of said plastic housing towards the corresponding sides into the reflection cup.

5. The surface-mount LED with optical lens according to claim 4, wherein the LED chip is mounted on the cathode lead, wherein one electrode of the LED chip is connected to the cathode lead, while the other electrode is connected to the anode lead.

6. The surface-mount LED with optical lens according to claim 4, wherein the LED chip is mounted on the anode lead, wherein one electrode of the LED chip is connected to the anode lead, while the other electrode is connected to the cathode lead.
